# EUROPÄISCHE PATENTSCHRIFT

(11) **EP 0 657 067 B1**
(45) Veröffentlichungstag und Bekanntmachung des Hinweises auf die Patenterteilung: **22.09.2004**
(21) Anmeldenummer: 94916120.2
(22) Anmeldetag: 06.06.1994
(51) Int. Cl.: H01L 31/0224, H01L 27/142, H01L 31/20, H01L 31/042

(54) **SOLARZELLENSYSTEM**
SOLAR CELL SYSTEM
SYSTEME DE CELLULES SOLAIRES

(30) Priorität: 29.06.1993 CH 195893
(43) Veröffentlichungstag der Anmeldung: 14.06.1995
(73) Patentinhaber: Enecolo AG, 8617 Mönchaltorf (CH)
(72) Erfinder: TOGGWEILER, Peter, CH-8617 Mönchaltorf (CH)
(74) Vertreter: Luchs, Willi
(86) Internationale Anmeldenummer: PCT/CH1994/000107
(87) Internationale Veröffentlichungsnummer: WO 1995/001654

(56) Entgegenhaltungen:
- EP-A- 0 111 394
- EP-A- 0 427 934
- DE-A- 4 017 860
- DE-A- 4 101 594
- US-A- 4 217 633

## Beschreibung

Die Erfindung betrifft eine Solarzellen-Anlage nach dem Oberbegriff des Anspruches 1. Eine bekannte Solarzelle nach der Druckschrift EP-A-0 111 394 besteht aus mehreren unterbrochenen Zellen. Die einzelnen Zellen weisen hierbei auf der Vorder- und auf der Rückseite je eine Leiterschicht auf. Diese Solarzellen sind teuer in der Herstellung, und zwar zum einen durch die Unterteilung in einzelne kleine Zellen und zum andern durch die erforderlichen elektrischen Verbindungen zwischen diesen. Zudem bestehen entsprechend inaktive Flächen, bei denen keine Energiegewinnung möglich ist.

Solarzellen-Anlagen sind vorbildlich umweltverträglich: Im Betrieb erzeugen sie weder Abgase noch Abwärme oder Geräusche.

Das technische Potential von Solarzellen-Anlagen zur Stromerzeugung ist weltweit sehr gross. Man kann sie so gut wie überall und für jeden Zweck einsetzen, zum Beispiel für dezentrale Energieversorgung abgelegener Siedlungen, für zentrale Stromerzeugung in Solarkraftwerken oder für Solarzellen-Generatoren auf Dächern oder Solarmobilen.

Wie weit das Potential der Solarzellen ausgeschöpft werden kann, hängt im wesentlichen davon ab, ob die Solarzellenentwicklung billigere Herstellungsverfahren findet - wenn ja, ist es denkbar, einen bedeutsamen Anteil der Stromerzeugung auch in den sonnenarmen Industriestaaten mit Solarzellen zu bestreiten.

Man suchte daher nach Mitteln und Wegen, um die Herstellungskosten von Solarzellen zu senken.

Die Solarzellen basieren auf dem sogenannten photovoltaischen Effekt: An der Grenzschicht zwischen zwei verschiedenartigen Halbleitern vermag Sonnenlicht Ladungsträger abzulösen, so dass eine elektrische Spannung entsteht. Im Detail sieht dies folgendermassen aus:
Wo ein Elektronen- oder n-Halbleiter an einen Löcher- oder p-Haltleiter (z.B. mit Spuren von Phosphor dotiertes Silizium) angrenzt, baut sich im Grenzbereich, dem p-n-Übergang, ein inneres, elektrisches Feld auf. Negativ geladene Elektronen wandern nämlich aus dem n- in den p-Halbleiter und Löcher (von Elektronen nicht besetzte, positive geladene Plätze) aus dem p- in den n-Halbleiter, um das Ladungsgefälle an der Grenzschicht auszugleichen. Wird nun Licht, z.B. Sonnenstrahlung, in der Grenzschicht absorbiert, löst es auf beiden Seiten Paare von Elektronen und Löchern ab. Unter dem Einfluss des inneren Feldes sammeln sich die Elektronen im n-Leiter und die Löcher im p-Leiter, wodurch zwischen den beiden Seiten eine dem inneren Feld entgegengesetzt gleiche Photospannung entsteht. Mit Kontakten kann man diese Photospannung abgreifen und zu einem Gleichstromkreis schliessen. Die Stromstärke nimmt mit der Beleuchtungsstärke und der Grösse der beleuchteten Fläche zu. Die Spannung ist von den Halbleitermaterialien abhängig. Handelsübliche kristalline Solarzellen messen bis zu 10 cm x 10 cm und geben etwa 0,5 Volt Spannung und 1 Watt Spitzenleistung ab. In Solarzellen-Anlagen braucht man jedoch höhere Spannungen und Leistungen. Gemäss dem heutigen Stand der Technik schalten die Hersteller daher mehrere Solarzellen hintereinander in Serie und verkapseln sie wetterfest unter Glas zu einem Solarmodul, einer austauschbaren Einheit. Ein oder mehrere Module, durch Serie- oder Parallelschaltung auf die gewünschte Spannung oder Leistung gebracht, ergeben einen Solarzellen-Generator. Nach der Kristallform unterscheidet man drei Grundarten von Solarzellen, wobei Silizium als Halbleitermaterial vorherrscht:
Es gibt monokristalline Solarzellen. Sie werden hergestellt, indem aus der Silizium-Schmelze ein p-leitender SiliziumEinkristall gezogen und in etwa 0,4 mm dicke Scheiben gesägt wird. Die der Sonnenstrahlung zugewandte Vorderseite dotiert man durch Eindiffundieren z.B. von Phosphor drei bis vier Tausendstelmillimeter tief n-leitend, wodurch der für das Prinzip entscheidende p-n-Übergang entsteht. Beidseits werden Metallkontakte für die Stromabnahme aufgedampft, auf der Vorderseite als Gitter, das nicht mehr als 10 Prozent der Fläche abdeckt, um möglichst viel Sonnenstrahlung durchzulassen. Die grössten Kristalle bzw. Scheiben haben einen Durchmesser von etwa 15 cm.

Um die einzelnen Solarzellen in Serie zu einem Modul zusammenzuschalten, wird der positive Metallkontakt jeder Solarzelle durch Kontaktverbinder mit dem negativen Metallkontakt einer angrenzenden Solarzelle verbunden, oder umgekehrt. Durch diese Serieschaltung entstehen zwischen den Solarzellen eines Moduls räumliche Lücken, sogenannte inaktive Bereiche, wo die Sonnenenergie ungenutzt bleibt.

Im weiteren sind polykristalline Solarzellen bekannt, welche hergestellt werden, indem aus Silizium ein aus vielen kleinen Kristallen bestehender Block gegossen, zersägt und wie der Einkristall weiterbehandelt wird. Ihr Wirkungsgrad ist niedriger als derjenige von monokristallinen Solarzellen. Schliesslich kennt man noch die Dünnschichtzellen. Dabei handelt es sich um einen Tausendstelmillimeter dünnen p-i-n-Sandwich (p-Leiter, undotierter intrinsic-Halbleiter und n-Leiter), welcher auf Glas, Film oder Metallband nach verschiedenen Verfahren, z.B. Aufdampfen oder Abscheiden, aufgebracht wird. Dieser p-i-n-Sandwich ist nicht als Ein- oder Vielkristall ausgebildet, sondern bleibt amorph (strukturlos). Der i-Leiter ist nötig, weil im amorphen p- und n-Leiter sonst zu viele Rekombination stattfänden und der Wirkungsgrad schlechter wäre. Die Stromabnahme geschieht an der Vorderseite durch eine durchsichtige, leitfähige Schicht aus Zinnoxid und an der Rückseite durch eine Kontaktschicht aus Aluminium.

Solche Zellen können grundsätzlich beliebig gross gemacht werden. Die Schichten werden ohne Unterbrüche aufgetragen. Um dennoch die notwendige Spannung zu erreichen, werden die Schichten nachträglich mit einem aufwendigen Verfahren mit Hilfe von Laserschneidern unterbrochen. Sowohl die vordere als auch die hintere Kontaktschicht wird in regelmässigen Abständen durch gerade Rillen unterbrochen und dadurch in eine Vielzahl von Zellen unterteilt. Die Rillen der oberen Kontaktschicht sind dabei gegen die Rillen der unteren Kontaktschicht geringfügig versetzt, so dass sich der Randbereich der vorderen Kontaktschicht einer Zelle und der Randbereich der hinteren Kontaktschicht der angrenzenden Zelle überlappen. Die beiden überlappenden Bereiche sind durch einen flachen Steg aus Silber oder einem anderen leitenden Material, welcher rechtwinklig zu den Kontaktschichten und parallel zu den beiden angrenzenden Rillen verläuft, miteinander verbunden. Benachbarte Zellen werden dadurch ebenfalls in Serie geschaltet.

Die so entstehenden Module haben den Nachteil, dass sie in den Bereichen der Silberstege die Sonnenenergie nicht ausnützen können, d.h. inaktiv sind. Ihre Herstellung ist ausserdem sehr zeitaufwendig und mit entsprechend hohen Kosten verbunden. Die für das Unterbrechen der Schichten notwendigen Laserschneidmaschinen sind ausserdem sehr teuer. Beim Laserschneiden entsteht auch viel unnötiger und umweltbelastender Abfall. Das Wiederherstellen der Verbindungen zwischen den Zellen ist ebenfalls aufwendig und teuer.

Der vorliegenden Erfindung liegt die Aufgabe zugrunde, ein Solarzellensystem mit einer oder mehreren amorphen Dünnschichtzellen zu schaffen, dessen Herstellung ohne Schneiden der Halbleiterschicht möglich ist und dessen Module keine oder zumindest weniger inaktive Bereiche aufweisen.

Die Aufgabe wird erfindungsgemäss mit Hilfe der Ausbildungsmerkmale nach dem kennzeichnenden Teil des Patentanspruches 1 gelöst.

Beim Solarzellensystem, welches Gegenstand der vorliegenden Erfindung ist, wird die von den Verbrauchern benötigte Spannungshöhe des von einem Solarzellen-Generator produzierten, elektrischen Gleichstromes dadurch erreicht, dass die Dünnschichtsolarzellen mit elektronischen Spannungsumsetzern gekoppelt werden und nicht wie bisher durch die Serieschaltung einer Vielzahl von einzelnen Solarzellen. Bei diesem Solarzellensystem ist eine einzelne Dünnschichtsolarzelle entweder in ihrer Fläche begrenzt, oder aber unbegrenzt, falls die Dünnschichtzelle mit einem kontinuierlichen Herstellungsverfahren (z.B. mit einer Bandfabrikation) produziert wird. Mit solchen Verfahren lassen sich Dünnschichtzellen mit mehr oder weniger unbegrenzter Fläche herstellen.

Die grossflächigen Dünnschichtsolarzellen des vorgeschlagenen Solarzellensystems sind mindestens gleich gross wie früher ein ganzes Solarmodul.

Sie sind im weiteren mit speziellen Stromabnehmersystemen ausgerüstet, welche die hohen Ströme abzuleiten vermögen.

Je zwei solche Solarzellen können entweder parallel geschaltet oder in einer Mittelpunktschaltung eingeschlossen sein.

Die Erfindung ist unter anderem in den Zeichnungen erläutert. Es zeigen:
- Fig. 1a: Aufsicht auf einen Solarzellen-Generator, bestehend aus zwei grossflächigen, parallel geschalteten Dünnschichtsolarzellen, kombiniert mit einem Spannungsumsetzer
- Fig. 1b: Querschnitt eines Solarzellen-Generators, bestehend aus zwei grossflächigen, parallel geschalteten Dünnschichtsolarzellen im Bereiche zweier Querabnehmer
- Fig. 2: Schematischer Aufbau einer Dünnschichtsolarzelle, kombiniert mit einem elektronischen Spannungsumsetzer
- Fig. 3a: Aufsicht auf einen Solarzellen-Generator, bestehend aus zwei grossflächigen Dünnschichtsolarzellen, welche in einer Mittelpunktschaltung eingeschlossen und mit einem elektronischen Spannungsumsetzer kombiniert sind
- Fig. 3b: Querschnitt eines Solarzellen-Generators, bestehend aus zwei grossflächigen, in einer Mittelpunktschaltung eingeschlossenen Dünnschichtsolarzellen im Bereiche der vordersten Querabnehmer

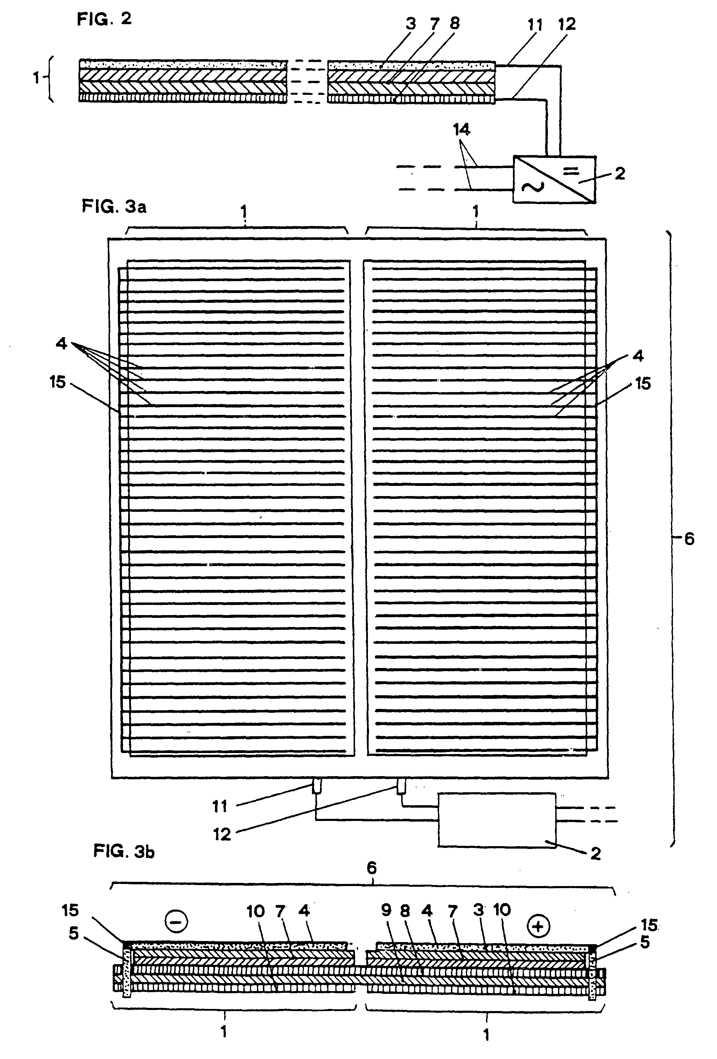

Die wesentlichen Elemente des vorgeschlagenen Solarzellensystems sind grossflächige, amorphe Dünnschichtsolarzellen 1 und elektronische Spannungsumsetzer 2 (vgl. Fig. 2). Diese Spannungsumsetzer 2 dienen dazu, die elektrische Spannung des von den Dünnschichtsolarzellen 1 produzierten, elektrischen Gleichstromes von etwa 0,5 Volt auf 10 oder mehr Volt zu erhöhen. Die Verbraucher benötigen normalerweise Strom mit mindestens 10 Volt Spannung.

Die Dünnschichtsolarzellen 1 werden also nicht wie bisher in einzelne Stücke unterteilt, sondern werden ganz belassen und der resultierende elektrische Strom wird mit elektronischen Hilfsmitteln in die gewünschte Form, wie zum Beispiel auf das gewünschte Spannungsniveau oder in die richtige Frequenz, umgewandelt.

Da die Dünnschichtsolarzellen 1 nicht in Serie geschaltet sind, hat der elektrische Strom, welcher von ihnen abgenommen wird, lediglich eine Spannung von z.B. 0,5 Volt. Entsprechend gross ist aber seine Stromstärke (etwa 120 A). Das vorgeschlagene Solarzellensystem verfügt über ein Stromabnehmersystem, welches solche grossen Ströme abzuleiten vermag. Das Stromabnehmersystem ist in geeigneter Art und Weise mit den Solarzellenschichten verbunden.

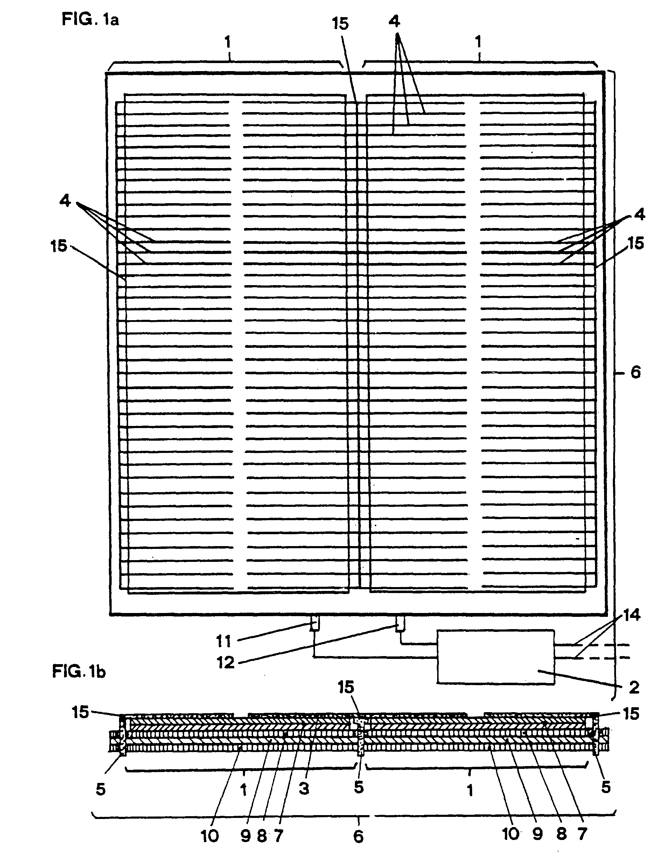

Ein Solarzellen-Generator 6 besteht aus einer oder mehreren Dünnschichtsolarzellen 1, welche an einem oder mehreren Spannungsumsetzern 2 angeschlossen sind. Bei Solarzellen-Generatoren 6 mit mehreren Dünnschichtsolarzellen 1 sind diese entweder parallel geschaltet oder dann paarweise in einer Mittelpunktschaltung eingeschlossen. Bei Parallelschaltung der Dünnschichtsolarzellen 1 (vgl. Fig. 1) weist der resultierende elektrische Strom eine Spannung von etwa 0,5 Volt, bei paarweiser Mittelpunktschaltung (vgl. Fig. 3) eine Spannung von etwa 1 Volt auf.

Die verwendeten Dünnschichtsolarzellen 1 können beliebig gross sein, da man sie mit.einem kontinuierlichen Herstellungsverfahren (z.B. mit einer Bandfabrikation) produzieren kann.

Sie weisen mehrere ununterbrochene Schichten auf: Bei der vordersten Schicht handelt es sich um eine Kontaktschicht 3 zur Abnahme des entstehenden elektrischen Gleichstromes. Bei einer bevorzugten Ausbildungsart besteht sie aus einer Vielzahl von Querabnehmern 4 aus einem leitenden Material, welche parallel zu den Querseiten der Dünnschichtsolarzelle 1 verlaufen und in leistenförmigen Längsleitern 15 münden.

In der Figur 1 ist ein Solarzellen-Generator 6 mit zwei parallelgeschalteten Dünnschichtsolarzellen 1 dargestellt. Die Dünnschichtsolarzellen 1 grenzen mit ihren Längsseiten aneinander. Ein mittlerer Längsleiter 15 ist zwischen den beiden Dünnschichtsolarzellen 1 angeordnet, je ein weiterer äusserer Längsleiter 15 verläuft entlang jeder äusseren Längsseite der beiden Dünnschichtsolarzellen 1. Vom mittleren Längsleiter 15 zweigen beidseits eine Vielzahl von Querabnehmern 4 ab, welche rechtwinklig zum mittleren Längsleiter 15 verlaufen. Von den beiden äusseren Längsleitern 15 zweigen lediglich an der Innenseite Querabnehmer 4 ab. Die Querabnehmer 4 sind alle etwa gleich lang.

Je ein Querabnehmer 4 der beiden äusseren Längsleitern 15 und zwei Querabnehmer 4 des mittleren Längsleiters 15 liegen in einer Linie.

Bei einer bevorzugten Ausbildungsart ist ihre Länge etwas kleiner als die halbe Breite der aktiven p-i-n-Schicht 7. Die Querabnehmer 4 des mittleren und des äusseren Längsleiters 15 berühren sich also in der Mitte der Dünnschicht-solarzellen 1 nicht.

Es ist aber auch eine Ausbildungsart möglich, bei der die Länge der Querabnehmer 4 so gross ist, dass jeder Querabnehmer 4 der äusseren Längsleiter 15 denjenigen Querabnehmer 4 des mittleren Längsleiters 15 berührt, welcher mit ihm auf einer Linie liegt und ihm zugewandt ist (nicht gezeigt). Dies stört nicht, da alle Querabnehmer 4, welche in einer Linie liegen, das gleiche Potential haben.

Die Längsleiter 15 sind etwas kürzer als die aktive p-i-n-Schicht 7. Sie weisen die gleiche Dicke auf wie die Querabnehmer 4. In regelmässigen Abständen ragen an ihrer Unterseite rechtwinklig mehrere leistenförmige Durchführungen 5 ab. Die Länge dieser Durchführungen 5 ist etwas grösser als die Dicke einer Dünnschichtsolarzelle 1 (vgl. Fig. 1b).

In der Figur 3 ist ein Solarzellen-Generator 6 mit zwei in einer Mittelpunktschaltung eingeschlossenen Dünnschichtsolarzellen 1 abgebildet.

In diesem Fall verläuft je ein leistenförmiger Längsleiter 15 entlang der äusseren Längsseite jeder Dünnschichtsolarzelle 1. Von den beiden Längsleitern 15 zweigen an der Innenseite Querabnehmer 4 ab, welche ebenfalls rechtwinklig zu den Längsleitern 15 verlaufen und deren Länge etwas kleiner ist als die Breite der aktiven p-i-n-Schicht 7. Die Querabnehmer 4 reichen also nicht ganz bis an die inneren Längsseiten der aktiven p-i-n-Schicht 7. Die beiden Längsleiter 15 weisen vorzugsweise die gleiche Anzahl Querabnehmer 4 auf.

Die Längsleiter 15 sind auch in diesem Fall etwas kürzer als die aktive p-i-n-Schicht 7 und etwa gleich dick wie die Querabnehmer 4 (vgl. Fig. 3b).

An ihrer Unterseite ragen in regelmässigen Abständen mehrere leistenförmige Durchführungen 5 rechtwinklig ab. Die Länge dieser Durchführungen 5 ist etwas grösser als die Dicke einer Dünnschichtsolarzelle 1 (vgl. Fig. 1b).

Direkt hinter der vorderen Kontaktschicht 3 ist die aktive p-i-n-Schicht 7 (Halbleiterschicht) angeordnet.

Bei der Ausbildungsart eines Solarzellen-Generators 6 mit zwei parallel geschalteten Dünnschichtsolarzellen 1 haben die p-i-n-Schichten 7 beider Dünnschichtsolarzellen 1 den gleichen Aufbau. Es ist nicht notwendig, dass die p-i-n-Schichten 7 der beiden Dünnschichtsolarzellen 1 voneinander getrennt sind. Neben der Variante mit zwei getrennten p-i-n-Schichten 7 ist auch eine Variante möglich, bei welcher die p-i-n-Schichten 7 beider Dünnschichtsolarzellen 1 zusammenhängend sind, d.h. aus einer einzigen Platte bestehen.

Bei der Ausbildungsart eines Solarzellen-Generators 6 mit paarweise in einer Mittelpunktschaltung eingeschlossenen Dünnschichtsolarzellen 1, sind jedoch der p-i-n-Schicht-Aufbau der einen Dünnschichtsolarzelle 1 und der p-i-n-Schicht-Aufbau der anderen Dünnschichtsolarzelle 1 genau umgekehrt. Das heisst, dass bei der p-i-n-Schicht 7 der einen Dünnschichtsolarzelle 1 der negative Pol vorne bzw. der positive hinten, und bei der anderen Dünnschichtsolarzelle 1 umgekehrt der positive Pol vorne bzw. der negative hinten liegt.

Hinter der aktiven p-i-n-Schicht 7 befindet sich eine zwischenliegende Leiterschicht 8.

Bei der Ausbildungsart eines Solarzellen-Generator 6 mit zwei parallelgeschalteten Dünnschichtsolarzellen 1 ist die zwischenliegende Leiterschicht 8 durchgehend. Sie wird lediglich in der Mitte durch die Durchführungen 5 unterbrochen. Ihre Breite ist etwas grösser als die Summe der Breiten der p-i-n-Schichten 7 und ihre Länge ist etwas grösser als die Länge der p-i-n-Schichten 7.

Bei der Ausbildungsart eines Solarzellen-Generators 6 mit zwei in einer Mittelpunktsschaltung eingeschlossenen Dünnschichtsolarzellen 1 ist die zwischenliegende Leiterschicht 8 ebenfalls durchgehend (vgl. Fig. 3b). Sie wird aber in diesem Fall in der Mitte nicht durch Durchführungen 5 unterbrochen. Die Gesamtbreite der durchgehenden, zwischenliegenden Leiterschicht 8 ist etwas breiter als die Summe der Breiten der beiden p-i-n-Schichten 7, ihre Länge ist etwas grösser als die Länge der p-i-n-Schichten 7.

Die Durchführungen 5 durchdringen diese zwischenliegenden Leiterschichten 8 und sind gegenüber diesen isoliert.

Hinter der zwischenliegenden Leiterschicht 8 folgt eine Isolierschicht 9. Sie erstreckt sich bei beiden Ausbildungsarten eines Solarzellen-Generators 6 über die gesamte Fläche der zwischenliegenden Leiterschicht 8. Die Isolierschicht 9 wird ebenfalls durch die Durchführungen 5 unterbrochen (vgl. Fig. 3b).

Zuhinterst liegt schliesslich noch eine hintere Leiterschicht 10. Bei derjenigen Ausbildungsart eines Solarzellen-Generators 6 mit parallel geschalteten Dünnschichtsolarzellen 1 sind die hinteren Leiterschichten 10 der beiden Solarzellen 1 durchgehend. Die hintere Leiterschicht 10 steht über die Durchführungen 5 und die Längsleiter 15 mit den Querabnehmern 4 in Kontakt. Die Leiterschichten 8 und 10 haben einen grossen Querschnitt und dienen als Hochstromleiter, welche den erzeugten elektrischen Strom zu den Stromanschlüssen 11, 12 der Dünnschichtsolarzellen leiten, an denen der Spannungsumsetzer 2 angeschlossen ist.

Bei derjenigen Ausbildungsart eines Solarzellen-Generators 6 mit paarweise in einer Mittelpunktschaltung eingeschlossenen Dünnschichtsolarzellen 1, sind die hinteren Leiterschichten 10 der beiden Dünnschichtsolarzellen 1 nicht durchgehend. Die hintere Leiterschicht 10 jeder Dünnschichtsolarzelle 1 steht über die Durchführungen 5 mit den Querabnehmern 4 an der Vorderseite derselben Dünnschichtsolarzelle 1 in Verbindung.

Die Leiterschichten 8 und 10 haben einen grossen Querschnitt und dienen auch hier als Hochstromleiter. Die zwischenliegende Leiterschicht 8 verbindet dabei den Pluspol der einen Dünnschichtsolarzelle 1 mit dem Minuspol der anderen Dünnschichtsolarzellen 1. Die beiden hinteren Leiterschichten 10 leiten den durch die beiden Dünnschichtsolarzellen 1 erzeugten Strom zu den beiden Stromanschlüssen 11, 12.

An den beiden Stromanschlüssen 11, 12 ist der elektronische Spannungsumsetzer 2 angeschlossen, welcher die Spannung des von den Dünnschichtsolarzellen 1 erzeugten Gleichstromes auf die für die Verbraucher geeignete Höhe wandelt. Die Spannungshöhe richtet sich nach dem jeweiligen Bedarf und liegt im Bereich von 10 - 400 Volt.

Es werden Spannungsumsetzer 2 gängiger Art verwendet, deren Elemente nach heutiger Technologie gefertigt sind, welche die Belastung durch hohe Stromstärken erlaubt.

Zur Erzeugung von Wechselstrom kann als Spannungsumsetzer 2 ein DC/AC-Wandler eingesetzt werden.

Der Spannungswandler 2 wird vorzugsweise direkt auf die Leiterschichten aufgesetzt, wodurch Spannungsabfälle auf den Zuleitungen vermieden werden können.

Der Spannungsumsetzer 2 speist den elektrischen Strom mit erhöhter Spannung in das Verbrauchernetz 14 ein.

Es ist im weiteren vorgesehen, nicht nur Dünnschichtsolarzellen 1 mit einem einzigen p-n-Übergang zu verwenden, sondern auch Dünnschichtsolarzellen mit mehreren p-n-Übergängen, sogenannte Multilayer-Zellen, in der oben beschriebenen Art und Weise zu einem Solarzellen-Generator 6 zusammenzustellen. Dies hat den Vorteil, dass die Zellenspannung höher ist. Bei Dualzellen mit zwei p-n-Übergängen beträgt die Zellenspannung zum Beispiel 1 Volt, bei einer Tripelzelle mit drei p-n-Übergängen 1.5 Volt.

Das vorgeschlagene Solarzellensystem weist gegenüber den bisher bekannten Solarzellensystemen, bei welchen eine Vielzahl kleinflächiger Solarzellen in Serie geschaltet waren, wesentliche Vorteile auf:
Da beim vorgeschlagenen Solarzellensystem grossflächige, nicht unterbrochene Dünnschichtsolarzellen 1 eingesetzt werden können, ist das aufwendige, teure Laserschneiden und das anschliessende Verbinden der einzelnen Zellen nicht mehr notwendig. Dies führt zu einer wesentlichen Vereinfachung des Fabrikationsprozesses. Für die Herstellung solcher grossflächigen Dünnschichtsolarzellen 1 braucht man weniger Material und es entsteht weniger Abfall als bei den bisher verwendeten, kleinflächig unterteilten Dünnschichtsolarzellen 1.

Im weiteren ist der Systemwirkungsgrad der Solarzellen-Generatoren 6 des vorgeschlagenen Solarzellensystems höher, weil einerseits der sogenannte Solarzellen-Miss-Match wegfällt und andererseits die grossflächigen Module weniger inaktive Bereiche aufweisen als die bisher verwendeten Module mit kleinflächigen Dünnschichtsolarzellen.

Schliesslich hat das vorgeschlagene Solarzellensystem noch den Vorteil, dass die elektrische Spannung in den Dünnschichtsolarzellen 1 sehr niedrig ist, und dadurch keine Probleme mit der Spannungsfestigkeit auftreten. Die Isolation der Leiter gestaltet sich dadurch wesentlich weniger aufwendig als bei den bisher verwendeten Solarmodulen.

Dank des vorgeschlagenen Solarzellen-Systems lassen sich die Herstellungskosten von Solarzellen-Generatoren wesentlich senken. Ein Grund für die niedrigen Herstellungskosten liegt darin, dass beim vorgeschlagenen Solarzellen-Systemen die Dünnschichtsolarzellen 1 in einem kontinuierlichen Prozess, zum Beispiel in einer Bandfabrikation, hergestellt werden können.

Dies wird dazu beitragen, dass die Solarenergie auch in den sonnenarmen Industriestaaten wirtschaftlich interessant wird.

## Patentansprüche

1. Solarzellen-Anlage mit wenigstens einer amorphen Dünnschicht-Solarzelle mit einer Halbleiterschicht, welche Stromabnehmer (3, 8) an der Vorder- und Rückseite aufweist, wobei der Stromabnehmer an der Rückseite der Halbleiterschicht (7) aus einer ersten Leiterschicht (8) besteht, **dadurch gekennzeichnet, dass**
der Stromabnehmer an der Vorderseite der keine Unterbrechungen aufweisenden Halbleiterschicht (7) mit einer durch eine Isolierschicht (9) von der ersten Leiterschicht (8) getrennten zweiten Leiterschicht (10) verbunden ist, wobei sich die Isolierschicht (9) über die gesamte Fläche der ersten Leiterschicht (8) erstreckt und diese Leiterschichten (8, 10) und die dazwischenliegende elektrisch isolierende Schicht (9) auf der Rückseite der Halbleiterschicht (7) übereinanderliegend angeordnet sind, und der Stromabnehmer an der Vorderseite der Halbleiterschicht wenigstens einen Längsleiter (15) aufweist, der mittels Durchführungen (5), welche die an der Rückseite der Halbleiterschicht (7) angeordnete erste Leiterschicht (8) durchdringen und gegenüber dieser isoliert sind, mit der zweiten Leiterschicht (10) dektrisch leitend verbunden ist, wobei die Stromabnehmer mit wenigstens einem Spannungsumsetzer (2) verbunden sind.

2. Solarzellen-Anlage nach Anspruch 1, **dadurch gekennzeichnet, dass** wenigstens zwei Solarzellen (1) vorgesehen sind, die mit ihren Längsseiten nebeneinander angeordnet sind.

3. Solarzellen-Anlage nach Anspruch 1, **dadurch gekennzeichnet, dass** der Stromabnehmer an der Vorderseite der Halbleiterschicht (7) eine Vielzahl von Querabnehmern (4) aufweist, die sich quer zu besagtem längsleiter (15) erstrecken und in diesen münden.

## Claims

1. Solar cell system comprising at least one amorphous thin-layer solar cell having a semiconductor layer; which having current collectors (3, 8) at the front and rear side, whereby the current collector at the rear side of said semiconductor layer (7) comprises a first conductive layer (8), **characterized in that**
the current collector at the front side of the semiconductor layer (7) having no interruptions is connected with a second conductive layer (10), which is separated from the first conductive layer (8) by an insulating layer (9), whereby the insulating layer (9) is extending over the whole surface of the first conductive layer (8), and these conductive layers (8, 10) and the inbetween lying electrically insulating layer (9) of the rare side of the semiconductor layer (7) are arranged in spaced adjacency, and the current collector at the front side of the semiconductor layer comprises at least one longitudinal conductor (15), which is electrically conductive connected with the second conductive layer (10) by lead-throughs (5), which penetrate the conductive layer (8) arranged at the back side of the semiconductor layer (7) and are insulated from them, whereby the current collectors are connected with at least one voltage converter (2).

2. Solar cell system according to claim 1, **characterized in that** at least two solar cells (1) are provided, which are arranged side by side with their length sides.

3. Solar cell system according to claim 1, **characterized in that** the current collector at the front side of the semiconductor layer (7) comprises a multitude of transverse collectors (4), which extend transverse to the mentioned longitudinal conductors (15) und lead into them.

## Revendications

1. Installation à cellules solaires comportant au moins une cellule solaire amorphe en couche mince dotée d'une couche de semi-conducteur qui comporte des récepteurs de courant (3, 8) sur la face avant et la face arrière, le récepteur de courant sur la face arrière de la couche de semi-conducteur (7) étant constitué d'une première couche conductrice (8),
**caractérisée en ce que** le récepteur de courant sur la face avant de la couche de semi-conducteur (7), qui ne comporte aucune discontinuité, est relié à une deuxième couche conductrice (10) séparée de la première couche conductrice (8) par une couche isolante (9), la couche isolante (9) s'étendant sur toute la surface de la première couche conductrice (8), ces couches conductrices (8, 10) et la couche diélectrique intermédiaire (9) étant disposées l'une au-dessus de l'autre sur la face arrière de la couche de semi-conducteur (7), et le récepteur de courant sur la face avant de la couche de semi-conducteur comportant au moins un conducteur (15) de forme allongée qui est relié électriquement à la deuxième couche conductrice (10) au moyen de passages traversants (5) qui traversent la première couche conductrice (8) placée sur la face arrière de la couche de semi-conducteur (7) et qui sont isolés de celle-ci, les récepteurs de courant étant reliés à au moins un convertisseur de tension (2).

2. Installation à cellules solaires selon la revendication 1, **caractérisée en ce qu'**il est prévu au moins deux cellules solaires (1) qui sont disposées l'une à côté de l'autre au niveau de leurs grands côtés.

3. Installation à cellules solaires selon la revendication 1, **caractérisée en ce que** le récepteur de courant comporte sur la face avant de la couche de semi-conducteur (7) un grand nombre de récepteurs transversaux (4) qui s'étendent transversalement audit conducteur (15) de forme allongée et qui débouchent dans celui-ci.
